(19) Europäisches Patentamt
European Patent Office
Office européen des brevets

(11) EP 4 617 410 A1

(12) EUROPÄISCHE PATENTANMELDUNG

(43) Veröffentlichungstag:
17.09.2025 Patentblatt 2025/38

(51) Internationale Patentklassifikation (IPC):
C30B 23/06 (2006.01) C30B 29/36 (2006.01)
C30B 23/02 (2006.01)

(21) Anmeldenummer: 24162679.5

(22) Anmeldetag: 11.03.2024

(52) Gemeinsame Patentklassifikation (CPC):
C30B 29/36; C30B 23/025; C30B 23/063

(84) Benannte Vertragsstaaten:
AL AT BE BG CH CY CZ DE DK EE ES FI FR GB
GR HR HU IE IS IT LI LT LU LV MC ME MK MT NL
NO PL PT RO RS SE SI SK SM TR
Benannte Erstreckungsstaaten:
BA
Benannte Validierungsstaaten:
GE KH MA MD TN

(71) Anmelder: SiCrystal GmbH
90411 Nürnberg (DE)

(72) Erfinder:
• Schuh, Philipp
90411 Nürnberg (DE)

• Müller, Ralf
90411 Nürnberg (DE)
• Stockmeier, Matthias
90411 Nürnberg (DE)
• Vogel, Michael
90411 Nürnberg (DE)
• Ecker, Bernhard
90411 Nürnberg (DE)

(74) Vertreter: Rau, Schneck & Hübner
Patentanwälte Rechtsanwälte PartGmbB
Königstraße 2
90402 Nürnberg (DE)

(54) KEIMEINHEIT UND VORRICHTUNG ZUR ZÜCHTUNG EINES SIC-VOLUMENEINKRISTALLS

(57) Die Keimeinheit (1) ist für die Züchtung eines SiC-Volumeneinkristalls bestimmt und hat einen scheibenförmigen einkristallinen SiC-Keimkristall (2) mit einer an einer Scheiben-Vorderseite (4) angeordneten Wachstumsoberfläche (4a) zum Aufwachsen des zu züchtenden SiC-Volumeneinkristalls. Der SiC-Keimkristall (2) hat eine in einer axialen Richtung verlaufende Kristallmittenlängsachse (6). Eine radiale Richtung ist senkrecht zur axialen Richtung orientiert. Die Keimeinheit (1) hat außerdem eine an einer Scheiben-Rückseite (5) des SiC-Keimkristalls (2) angeordnete Rückseiten-Schichtkomponente (3), deren Struktur sich ausgehend von der Kristallmittenlängsachse (6) in radialer Richtung verändert, so dass sich während der Züchtung des SiC-Volumeneinkristalls innerhalb des SiC-Keimkristalls (2) ein radialer Temperaturgradient einstellt.

Fig. 1

EP 4 617 410 A1

## Beschreibung

Die Erfindung betrifft eine Keimeinheit für die Züchtung eines SiC-Volumeneinkristalls sowie eine Vorrichtung zur Züchtung eines SiC-Volumeneinkristalls.

Das Halbleitermaterial Siliziumcarbid (SiC) wird aufgrund seiner herausragenden physikalischen, chemischen, elektrischen und optischen Eigenschaften unter anderem auch als Ausgangsmaterial für leistungselektronische Halbleiterbauelemente, für Hochfrequenzbauelemente und für spezielle lichtgebende Halbleiterbauelemente eingesetzt. Für diese Bauelemente werden SiC-Substrate (= SiC-Wafer) mit möglichst großem Substratdurchmesser und möglichst hoher Qualität benötigt. Basis hierfür sind hochwertige SiC-Volumeneinkristalle.

Solche SiC-Volumeneinkristalle werden in der Regel mittels physikalischer Gasphasenabscheidung (PVT), z.B. mittels eines in der US 8,865,324 B2 beschriebenen Sublimationsverfahrens, hergestellt. Dabei wird eine einkristalline SiC-Scheibe als SiC-Keimkristall zusammen mit geeignetem Quellmaterial in einen Züchtungstiegel eingebracht. Unter kontrollierten Temperatur-, Druck- und Gasbedingungen wird das Quellmaterial sublimiert. Die gasförmigen Spezies (= SiC, $Si_2C$, $SiC_2$) werden aufgrund eines axialen Temperaturgefälles (= Temperaturgradient) zu dem SiC-Keimkristall transportiert und scheiden sich dort aus der SiC-Wachstumsgasphase auf dem SiC-Keimkristall ab, wodurch der SiC-Volumeneinkristall aufwächst.

Aus diesen SiC-Volumeneinkristallen werden die scheibenförmigen einkristallinen SiC-Substrate beispielsweise mittels einer Fadensäge herausgeschnitten, die dann nach einer insbesondere mehrstufigen Polierbehandlung ihrer Oberflächen im Rahmen der Bauelementefertigung mit mindestens einer insbesondere auch aus SiC bestehenden Epitaxieschicht versehen werden. In der Regel werden Defekte aus dem SiC-Substrat in die aufgebrachte Epitaxieschicht vererbt und führen damit zu einer Verschlechterung der Bauelementeeigenschaften. Die Qualität der Bauelemente hängt also wesentlich von der des gezüchteten SiC-Volumeneinkristalls und der daraus gewonnenen SiC-Substrate ab.

Für die Herstellung der epitaktischen Schichten der Bauelemente ist die Geometrie des verwendeten SiC-Substrats von großer Bedeutung. So erreicht man in einem Epitaxie-Reaktor eine gute thermische Ankopplung, welche für homogenes und qualitativ hochwertiges epitaktisches Schichtwachstum sehr wichtig ist, im Wesentlichen nur bei SiC-Substraten, die keine nennenswerte Verbiegung aufweisen. Dagegen führen SiC-Substrate mit schlechten Geometrieeigenschaften, also insbesondere mit zu großer Verbiegung (engl.: bow) und/oder Wölbung (engl.: warp), zwangsläufig zu geringerer Qualität bzw. geringerer Ausbeute des Epitaxie-Prozesses.

Während der Züchtung des SiC-Volumeneinkristalls ist der axiale Temperaturgradient maßgeblich für den Materialtransport von dem Quellmaterial zum SiC-Keimkristall verantwortlich. Er sollte einerseits so groß sein, dass er zu wirtschaftlich sinnvollen Wachstumsgeschwindigkeiten führt, aber andererseits nicht so groß, dass sich verstärkt thermische Spannungen im Kristallvolumen ausbilden, die zu den oben beschriebenen Problemen bei den aus dem SiC-Volumeneinkristall hergestellten SiC-Substraten führen. Durch den im Züchtungstiegel herrschenden axialen Temperaturgradienten ergibt sich auch auf der Rückseite des SiC-Keimkristalls ein Temperaturunterschied zwischen der heißeren Scheiben-Rückseite des SiC-Keimkristalls und dem kälteren Tiegelbereich hinter dem SiC-Keimkristall. Um ein Abdampfen von Material von der Scheiben-Rückseite des SiC-Keimkristalls nach hinten und die damit einhergehende Defektbildung im auf der Scheiben-Vorderseite des SiC-Keimkristalls aufwachsenden SiC-Volumeneinkristall zu vermeiden, wird an dem SiC-Keimkristall eine Rückseitenpassivierung vorgenommen.

So wird in der CN 116121855 A beschrieben, dass der SiC-Keimkristall auf seiner Scheiben-Rückseite mit einer mehrlagigen Schutzschicht aus Kohlenstoff, insbesondere aus Graphit, versehen wird.

In der US 2011/0229719 A1 wird beschrieben, dass der SiC-Keimkristall auf seiner Scheiben-Rückseite zur Vermeidung von Materialabdampfung mit einer ein- oder mehrlagigen Schutzschicht aus hartem Kohlenstoff, aus diamantähnlichem Kohlenstoff, aus Diamant, aus Tantal oder aus Tantalcarbid versehen wird. Aus der US 2011/0229719 A1 geht außerdem hervor, dass der ggf. mit einer rückseitigen Schutzschicht versehene SiC-Keimkristall entweder mittels einer Klebeschicht oder mittels einer mechanischen Halterung an einem Tiegeldeckel des zur Züchtung verwendeten Tiegels befestigt wird.

In der CN 218860954 U wird ein anderer Ansatz beschrieben, bei dem die Temperatur innerhalb des SiC-Keimkristalls vereinheitlicht wird. Temperaturunterschiede und daraus resultierende innere Spannungen in dem SiC-Keimkristall sollen so vermieden werden. Hierzu wird auf der Rückseite der SiC-Keimkristalls eine mehrteilige thermische Isolation angeordnet, die ein verschiebbares Anpassungselement enthält. Durch dessen Verschiebung lässt sich ein auf der Rückseite des SiC-Keimkristalls ebenfalls vorhandener Hohlraum in seiner Abmessung an die jeweiligen (thermischen) Verhältnisse anpassen. Diese Konstruktion ist allerdings aufwändig und damit auch kostenträchtig.

In der CN 218175203 U wird eine auf der Rückseite des SiC-Keimkristalls angeordnete mehrteilige zusätzliche Heizanordnung beschrieben, deren Einzelteile verschoben werden können, um so das Temperaturfeld gezielt auch während des Züchtungsvorgangs verändern zu können. Auch diese Konstruktion ist aufwändig und kostenträchtig.

Die Aufgabe der Erfindung besteht deshalb darin, eine Keimeinheit sowie eine Vorrichtung der eingangs bezeichneten Art anzugeben, die gegenüber den bekannten Ansätzen eine einfachere und bessere Beeinflussung des Temperaturfelds im SiC-Keimkristall ermöglicht.

Zur Lösung der die Keimeinheit betreffenden Aufgabe wird eine Keimeinheit entsprechend den Merkmalen des Anspruchs 1 angegeben. Die erfindungsgemäße Keimeinheit hat einen scheibenförmigen einkristallinen SiC-Keimkristall mit einer an einer Scheiben-Vorderseite angeordneten Wachstumsoberfläche zum Aufwachsen des zu züchtenden SiC-Volumeneinkristalls, wobei der SiC-Keimkristall eine in einer axialen Richtung verlaufende Kristallmittenlängsachse hat, und eine radiale Richtung senkrecht zur axialen Richtung orientiert ist, und eine an einer Scheiben-Rückseite des SiC-Keimkristalls angeordnete Rückseiten-Schichtkomponente, deren Struktur sich ausgehend von der Kristallmittenlängsachse in radialer Richtung verändert, so dass sich während der Züchtung des SiC-Volumeneinkristalls innerhalb des SiC-Keimkristalls ein radialer Temperaturgradient einstellt.

Die Keimeinheit kann insbesondere auch als Keimsystem bezeichnet werden.

Der scheibenförmige SiC-Keimkristall hat insbesondere eine im Wesentlichen zylindrische Geometrie. Eine Umfangsrandfläche des SiC-Keimkristalls hat insbesondere im Wesentlichen die Form einer zylindrischen Mantelfläche.

Die Rückseiten-Schichtkomponente bedeckt den SiC-Keimkristall insbesondere vollständig. Sie kann bevorzugt aus einer Einzelschicht oder aus mehreren Einzelschichten bestehen. Unter der Struktur der Rückseiten-Schichtkomponente ist hier insbesondere die geometrische Abmessung der Rückseiten-Schichtkomponente und/oder die Materialzusammensetzung der Rückseiten-Schichtkomponente zu verstehen.

Während der Züchtung wächst der SiC-Volumeneinkristall in axialer Richtung auf dem SiC-Keimkristall auf und hat die gleiche Kristallmittenlängsachse wie der SiC-Keimkristall bzw. die Keimeinheit. Mit "axial" ist hier eine Richtung parallel zur oder längs der insbesondere zentralen Kristallmittenlängsachse, mit "radial" eine dazu senkrechte Richtung und mit "tangential" eine um die Kristallmittenlängsachse umlaufende Umfangsrichtung zu verstehen.

Es wurde erkannt, dass die Größe und die räumliche Verteilung der Temperaturunterschiede bzw. der Temperaturgradienten im Wachstumsbereich unter anderem direkt die Wachstumsrate, die Phasengrenzform und die thermischen Spannungen im wachsenden SiC-Volumeneinkristall beeinflussen. Die Spannungsverteilung im SiC-Volumeneinkristall beeinflusst ihrerseits den Versetzungshaushalt und auch die Verbiegung, die die später aus dem SiC-Volumeneinkristall hergestellten scheibenförmigen SiC-Substrate bei den weiteren Prozessschritten der Bauelementherstellung haben. Das dreidimensionale Temperaturfeld kann für die Betrachtung seiner Auswirkungen in eine axiale Komponente (bevorzugt axialer Temperaturgradient) in Richtung der Kristallmittenlängsachse und eine radiale Komponente (bevorzugt radialer Temperaturgradient) senkrecht zur Kristallmittenlängsachse oder parallel zur insbesondere ebenen Wachstumsoberfläche des SiC-Keimkristalls unterteilt werden. Beide Komponenten haben einen Einfluss auf die erreichbare Kristallqualität und sind deshalb zu berücksichtigen.

So beeinflusst der radiale Temperaturgradient die Form der Phasengrenze und somit der Oberfläche des wachsenden SiC-Volumeneinkristalls. Im Idealfall ist die Phasengrenze wenig konvex gekrümmt, so dass Störungen im Randbereich nicht nach innen wandern, aber nicht so konvex, dass durch eine zu starke Krümmung zu hohe Spannungen im SiC-Volumeneinkristall aufgebaut werden können. Spannungen im SiC-Volumeneinkristall führen zur Bildung vor allem von Basalebenenversetzungen (BPD), die die Langzeitstabilität der elektronischen Bauelemente, die aus den aus dem SiC-Volumeneinkristall gewonnenen SiC-Substraten hergestellt werden, negativ beeinflussen. Außerdem führen zu hohe Spannungen zu Verbiegungen des SiC-Substrats bei der weiteren Fertigung, was zu einer Verringerung der Ausbeute an verwertbaren Bauelementen führt.

Weiterhin wurde erkannt, dass durch eine optimierte Steuerung des kompletten Wärmeflusses von einer axialen Stirnseite des Züchtungstiegels zu der gegenüberliegenden anderen axialen Stirnseite des Züchtungstiegels, also vom SiC-Quellmaterial durch den SiC-Keimkristall bis hin zum Tiegeldeckel, das Temperaturprofil des gezüchteten SiC-Volumeneinkristalls dahingehend verbessert werden kann, dass Spannungen reduziert und in Folge dessen die Dichte der Basalebenenversetzungen auf ein Minimum verringert werden. Aus SiC-Volumeneinkristallen, die mit diesem verbesserten Temperaturprofil hergestellt werden, lassen sich außerdem SiC-Substrate mit deutlich geringeren Verbiegungen gewinnen, was zu einer erhöhten Ausbeute für die später darauf hergestellten Bauteile führt. Das verbesserte Temperaturprofil beruht im Wesentlichen darauf, dass an der Scheiben-Rückseite des SiC-Keimkristalls eine Rückseiten-Schichtkomponente vorgesehen wird, mittels derer der Wärmetransport aus dem auf der Scheiben-Vorderseite aufwachsenden SiC-Volumeneinkristall gesteuert werden kann. Dank der Rückseiten-Schichtkomponente können der axiale Temperaturgradient und der radiale Temperaturgradient weitgehend getrennt und insbesondere auch weitgehend unabhängig voneinander eingestellt werden. So kann zum Beispiel durch die radiale Variation der Rückseiten-Schichtkomponente der radiale Temperaturgradient beeinflusst werden, ohne den axialen Temperaturgradienten signifikant zu verändern. Die Rückseiten-Schichtkomponente kann außer zur Einstellung des radialen Temperaturgradienten bevorzugt auch zur Rückseitenpassivierung dienen, also dazu, dass von der Scheiben-Rückseite des SiC-Keimkristalls kein Material abdampft. Sie hat insofern eine vorteilhafte Doppelfunktion und ist dann insbesondere auch eine rückseitenpassivierende Schutzschicht.

Ein wichtiger Aspekt für die Züchtung eines SiC-Volumeneinkristalls mittels der Keimeinheit ist die Regulierung des Temperaturabflusses vom hei-ßesten zum kältesten Punkt der Züchtungsvorrichtung. Dabei ist der hei-ßeste Punkt im Bereich des in den Züchtungstiegel in einen SiC-Vorratsbereich eingebrachten SiC-Quellmaterials (in Pulver- oder Feststoffform) und der kälteste Punkt an einer dem SiC-Vorratsbereich gegenüberliegenden axialen Stirnseite des Züchtungstiegels, also insbesondere an einem axial stirnseitigen Tiegeldeckel, der auf der von dem SiC-Vorratsbereich abgewandten Seite der Keimeinheit angeordnet ist. Nach dem Erreichen der entsprechenden Kombination aus Temperatur und Druck findet aufgrund der Einstellung eines entsprechenden Temperaturunterschieds zwischen dem SiC-Keimkristall der Keimeinheit und dem SiC-Quellmaterial ein gerichteter Materialtransport statt und das Kristallwachstum beginnt. Die Phasengrenzform (= Wachstumsgrenzfläche) des wachsenden SiC-Volumeneinkristalls hängt dabei vor allem auch von der Wärmeabfuhr durch die Keimeinheit in Richtung des Tiegeldeckels ab. Diese Wärmeabfuhr wird vorteilhafterweise durch die Rückseiten-Schichtkomponente mit radial variierender Struktur in der gewünschten Weise beeinflusst.

Die dem Transport von Wärme zugrunde liegenden physikalischen Prinzipien sind das Fouriersche Gesetz (1):

$$Q = \lambda * A * \frac{T1 - T2}{d} \qquad (1),$$

wobei Q die durch Wärmeleitung übertragene Wärmeleitung, T1 die Temperatur der wärmeren Oberfläche, T2 die Temperatur der kälteren Oberfläche, A die Fläche, durch die die Wärme strömt, $\lambda$ die Wärmeleitfähigkeit (= eine temperaturabhängige Stoffgröße) und d die Dicke des Körpers zwischen der kälteren und der wärmeren Oberfläche bezeichnet, und das Stefan-Boltzman Gesetz (2):

$$Q = \varepsilon * \sigma * A * T^4 \qquad (2),$$

wobei Q die von einem Körper ausgesendete Strahlungsleistung, $\varepsilon$ den Emissionsgrad des Körpers, $\sigma$ die Stefan-Boltzmann-Konstante, A die Fläche des Körpers und T die absolute Temperatur bezeichnet. Da die SiC-Züchtung oberhalb von 2000K stattfindet, dominiert bei der Herstellung des SiC-Volumeneinkristalls das Stefan-Boltzman Gesetz, welches den Wärmetransport durch Strahlung beschreibt, gegenüber dem Mechanismus der Wärmeleitung, die durch das Fouriersche Gesetz abgebildet wird.

Die erfindungsgemäße Keimeinheit beruht vorzugsweise auf einer örtlich definierten Kombination aus beiden Wärmetransportmechanismen, die eine Homogenisierung oder optimierte Einstellung der lokalen Temperaturunterschiede begünstigt. Dadurch kann eine sehr gute Phasengrenzform des wachsenden SiC-Volumeneinkristalls generiert werden. Weiterhin können dadurch die inneren Spannungen im Kristallgefüge und die Defektdichte stark reduziert werden. Insbesondere weist ein guter SiC-Volumeneinkristall einerseits eine nur sehr wenig gekrümmte Phasengrenze auf, was zu stark reduzierten Spannungen innerhalb des Kristallgefüges führt. Insbesondere ist aber andererseits auch eine leicht konvexe Krümmung erwünscht, um zu verhindern, dass Defekte, die im Randbereich des aufwachsenden SiC-Volumeneinkristalls entstehen, in den für die weitere Prozessierung zur Bauelemente-Herstellung besonders wichtigen hochwertigen inneren Bereich vordringen. Um dies zu erreichen, weist die erfindungsgemäße Keimeinheit die insbesondere ein- oder mehrlagige Rückseiten-Schichtkomponente mit radial variierender Struktur auf, deren Einzelschichten unterschiedliche chemische und/oder physikalische Eigenschaften bei radial konstanter oder radial variabler Dicke haben können. Dadurch wird der Wärmetransport durch Strahlung und Wärmeleitung so eingestellt wird, dass nahezu ideale Werte für den radialen und bevorzugt auch für den axialen Temperaturgradienten erreicht werden. Auch rückseitig des SiC-Keimkristalls angeordnete Hohlräume können den beschriebenen Effekt begünstigen. Diese Maßnahmen können einzeln zur Anwendung kommen oder auch beliebig miteinander kombiniert werden.

Bisherige Rückseitenbeschichtungen von SiC-Keimkristallen hatten die Funktion, das Abdampfen von Material nach hinten und die damit einhergehende Defektbildung zu vermeiden, ohne jedoch gezielt Einfluss auf die Temperaturverteilung bzw. die Temperaturgradienten im SiC-Keimkristall und in anderen Bereichen des zur Züchtung eines SiC-Volumeneinkristalls eingesetzten Züchtungstiegels zu nehmen.

Außerdem erfolgt die Einstellung des Temperaturfelds während der Züchtung eines SiC-Volumeneinkristalls bisher über geometrische Maßnahmen am Züchtungstiegel und/oder an der den Züchtungstiegel umgebenden thermischen Isolation. Dadurch sind aber der axiale Temperaturgradient und der radiale Temperaturgradient fast immer gekoppelt und praktisch nicht getrennt voneinander einstellbar.

Die erfindungsgemäße Keimeinheit, bei der der radiale Temperaturgradient durch eine geeignete Modifikation an der Scheiben-Rückseite des SiC-Keimkristalls, nämlich durch die dortige Platzierung der Rückseiten-Schichtkomponente mit ihrer in radialer Richtung variierenden Struktur, eingestellt werden kann, ermöglicht es, die Temperaturgradienten in radialer und in axialer Richtung gezielt und auch weitgehend getrennt voneinander zu optimieren, ohne dabei einen anderen unerwünschten Einfluss auf die übrigen Verhältnisse innerhalb des zur Züchtung eines SiC-Volumeneinkristalls eingesetzten Züchtungstiegels auszuüben. Vorteilhafterweise erfordert diese Modifikation an der Scheiben-Rückseite des SiC-Keimkristalls keinen voluminösen Erweiterungsumbau am Züchtungstiegel. Vielmehr bleibt der Züchtungstiegel so kompakt wie bisher. Ebenso bleiben anderweitige Variationsmöglichkeiten zur Optimierung des Gesamtaufbaus der Züchtungsvorrichtung erhalten. Außerdem wird der Temperaturgradient dadurch, dass die ihn beeinflussende Rückseiten-Schichtkomponente an der Scheiben-Rückseite des SiC-Keimkristalls, und dort insbesondere unmittelbar oder direkt anliegend, angeordnet ist, in nächster Nähe zu dem während der Züchtung auf dem SiC-Keimkristall aufwachsenden SiC-Volumeneinkristall eingestellt. Deshalb erfolgt die thermische Einflussnahme sehr direkt und effizient.

Die Keimeinheit ermöglicht somit aufgrund der verbesserten gezielten Beeinflussung des Temperaturfelds während des Züchtungsvorgangs eine massive Reduktion bei den inneren mechanischen Spannungen und bei den Versetzungen in dem gezüchteten SiC-Volumeneinkristall. Dies wirkt sich positiv auf die Qualität und die Ausbeute der nachfolgenden Prozessschritte aus. Außerdem ermöglicht die Keimeinheit die Konstruktion sehr kompakter und sehr flexibel einsetzbarer Züchtungsvorrichtungen.

Vorteilhafte Ausgestaltungen der erfindungsgemäßen Keimeinheit ergeben sich unter anderem aus den Merkmalen der von Anspruch 1 abhängigen Ansprüche.

Günstig ist eine Ausgestaltung, bei der die Rückseiten-Schichtkomponente aus einer Einzelschicht besteht. Die Rückseiten-Schichtkomponente ist dann insbesondere einlagig ausgeführt. Dadurch realisiert ein besonders einfacher und kostengünstiger Aufbau. Vorzugsweise hat die Einzelschicht eine axiale, d.h. eine insbesondere in axialer Richtung gemessene, Schichtdicke zwischen 0,5 μm und 10 μm, insbesondere zwischen 1 μm und 5 μm. Im Falle einer z.B. in radialer Richtung variierenden Schichtdicke bezeichnet diese Schichtdicke insbesondere die maximale Dicke bzw. Ausdehnung in axialer Richtung.

Gemäß einer weiteren günstigen Ausgestaltung besteht die Rückseiten-Schichtkomponente aus mehreren Einzelschichten. Die Rückseiten-Schichtkomponente ist dann insbesondere mehrlagig ausgeführt. Dadurch realisiert ein Aufbau, der sich sehr genau an den jeweiligen Anwendungsfall anpassen lässt. Bevorzugt ist zumindest ein Teil der mehreren Einzelschichten axial übereinander und/oder radial nebeneinander angeordnet. Vorzugsweise liegt eine axiale Gesamtschichtdicke aller Einzelschichten zwischen 0,5 μm und 20 μm, insbesondere zwischen 1 μm und 10 μm. Insbesondere haben alle Einzelschichten zusammengenommen eine gemeinsame axiale Gesamtschichtdicke. Im Falle einer z.B. in radialer Richtung variierenden Gesamtschichtdicke bezeichnet diese Gesamtschichtdicke insbesondere die maximale Dicke bzw. Ausdehnung in axialer Richtung. Bevorzugt haben die Einzelschichten zumindest zum Teil ein voneinander verschiedenes Schichtmaterial. Insbesondere bestehen sie zumindest zum Teil aus einem voneinander verschiedenen Schichtmaterial.

Gemäß einer weiteren günstigen Ausgestaltung besteht jede Einzelschicht der Rückseiten-Schichtkomponente aus einem Schichtmaterial, welches ein Material aus der Gruppe von Kohlenstoff und einem Carbid ist oder zumindest ein Material dieser Gruppe aufweist. Das Carbid ist insbesondere ein Metallcarbid.

Gemäß einer weiteren günstigen Ausgestaltung hat die Rückseiten-Schichtkomponente eine axiale Komponentendicke, die ausgehend von der Kristallmittenlängsachse in radialer Richtung zunimmt. Insbesondere nimmt die axiale Komponentendicke kontinuierlich oder mit diskreten Stufen zu. Insbesondere nimmt die axiale Komponentendicke in radialer Richtung ausgehend von der Kristallmittenlängsachse bis zu einem seitlichen Rand, beispielsweise bis zu einem Umfangsrand, der Rückseitenschichtkomponente um einen Faktor von 1,5 bis 20, vorzugsweise um einen Faktor von 1,75 bis 15 und bevorzugt um einen Faktor 2 oder einen Faktor 5 oder einen Faktor 10 zu.

Gemäß einer weiteren günstigen Ausgestaltung liegt die Rückseiten-Schichtkomponente direkt an der Scheiben-Rückseite des SiC-Keimkristalls an. Dadurch erfolgt die thermische Einflussnahme auf den SiC-Keimkristall und auf den während der Züchtung darauf aufwachsenden SiC-Volumeneinkristall sehr direkt und effizient. Insbesondere kann so der während der Züchtung herrschende radiale Temperaturgradient sehr wirksam beeinflusst und eingestellt werden.

Gemäß einer weiteren günstigen Ausgestaltung weist die Rückseiten-Schichtkomponente einen Schicht-Hohlraum auf. Der Schicht-Hohlraum ist insbesondere eingebettet, bevorzugt vollständig eingebettet. Der Schicht-Hohlraum hat vorzugsweise eine axiale Ausdehnung von bis zu 5 mm. Auch der Schicht-Hohlraum begünstigt die Beeinflussung und Einstellung des während der Kristallzüchtung im SiC-Keimkristall und in dem darauf aufwachsenden SiC-Volumeneinkristall herrschenden radialen Temperaturgradienten. Eine mit einem Schicht-Hohlraum ausgestattete Rückseiten-Schichtkomponente hat eine insbesondere in axialer Richtung gemessene maximale Komponentendicke vorzugsweise zwischen 2 mm und 15 mm, bevorzugt zwischen 3 mm und 10 mm.

Zur Lösung der die Vorrichtung betreffenden Aufgabe wird eine Vorrichtung entsprechend den Merkmalen des Anspruchs 14 angegeben. Die erfindungsgemäße Vorrichtung hat einen beheizbaren Züchtungstiegel mit einem in einem ersten Abschnitt angeordneten SiC-Vorratsbereich zur Aufnahme von SiC-Quellmaterial, und mit einem in einem zweiten Abschnitt angeordneten Kristallwachstumsbereich, eine Keimeinheit oder eine deren günstiger Ausgestaltungen gemäß vorstehender Beschreibung, und einen Keimhalter zur Halterung der Keimeinheit im Inneren des Züchtungstiegels, so dass zumindest die Wachstumsoberfläche des SiC-Keimkristalls der Keimeinheit in dem Kristallwachstumsbereich angeordnet ist.

Der erste Abschnitt und der zweite Abschnitt sind insbesondere jeweils im Inneren des Züchtungstiegels angeordnet und bevorzugt voneinander beabstandet. Vorzugsweise liegt der erste Abschnitt benachbart zu einer ersten axial stirnseitigen (z.B. unteren) Begrenzungswand des Züchtungstiegels.

Die erfindungsgemäße Vorrichtung und ihre Ausgestaltungen bieten im Wesentlichen die gleichen Vorteile, die bereits im Zusammenhang mit der erfindungsgemäßen Keimeinheit und deren Ausgestaltungen beschrieben worden sind.

Vorteilhafte Ausgestaltungen der erfindungsgemäßen Vorrichtung ergeben sich unter anderem aus den Merkmalen der von Anspruch 14 abhängigen Ansprüche.

Günstig ist eine Ausgestaltung, bei der auf einer von dem SiC-Vorratsbereich abgewandten Rückseite der Keimeinheit ein insbesondere rückseitiger Vorrichtungs-Hohlraum angeordnet ist, der insbesondere eine axiale Ausdehnung von bis zu 5 mm hat. Der Vorrichtungs-Hohlraum ist insbesondere durch einen freien Raum zwischen der Rückseite der Keimeinheit und einer zweiten axial stirnseitigen (z.B. oberen) Begrenzungswand des Züchtungstiegels, vorzugsweise einem Tiegeldeckel, gebildet.

Weitere Merkmale, Vorteile und Einzelheiten der Erfindung ergeben sich aus der nachfolgenden Beschreibung von Ausführungsbeispielen anhand der Zeichnung. Es zeigt:

Fig. 1          ein erstes Ausführungsbeispiel einer Keimeinheit zur Züchtung eines SiC-Volumeneinkristalls,

Fig. 2          ein Ausführungsbeispiel einer Vorrichtung zur Züchtung eines SiC-Volumeneinkristalls mit der Keimeinheit gemäß Fig. 1, und

Fig. 3 bis 7      weitere Ausführungsbeispiele von Keimeinheiten jeweils zur Züchtung eines SiC-Volumeneinkristalls.

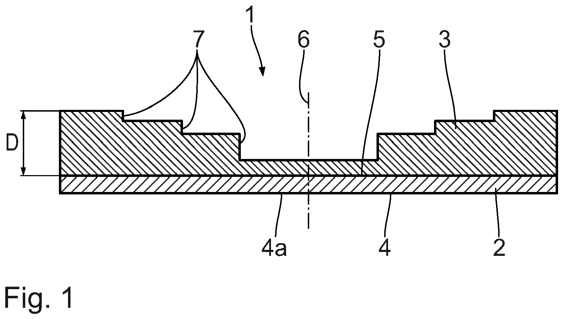

Einander entsprechende Teile sind in den Fig. 1 bis 7 mit denselben Bezugszeichen versehen. Auch Einzelheiten der im Folgenden näher erläuterten Ausführungsbeispiele können für sich genommen eine Erfindung darstellen oder Teil eines Erfindungsgegenstands sein.

In Fig. 1 ist ein Ausführungsbeispiel einer Keimeinheit 1 zur Sublimationszüchtung eines (nicht mit dargestellten) SiC-Volumeneinkristalls gezeigt. Die Keimeinheit 1 hat einen scheibenförmigen einkristallinen SiC-Keimkristall 2 sowie eine Rückseiten-Schichtkomponente 3. Der SiC-Keimkristall 2 hat eine Scheiben-Vorderseite 4, an der sich eine Wachstumsoberfläche 4a zum Aufwachsen des zu züchtenden SiC-Volumeneinkristalls befindet, sowie eine der Scheiben-Vorderseite 4 gegenüberliegende Scheiben-Rückseite 5. An der Scheiben-Rückseite 5 ist der SiC-Keimkristall 2 direkt mit der Rückseiten-Schichtkomponente 3 beschichtet. Der SiC-Keimkristall 2 und die Rückseiten-Schichtkomponente 3 liegen insofern unmittelbar aneinander an. Die Rückseiten-Schichtkomponente 3 bedeckt den SiC-Keimkristall 2 an dessen Scheiben-Rückseite 5 komplett.

Der SiC-Keimkristall 2 und auch die Keimeinheit 1 insgesamt haben eine zentrale Kristallmittenlängsachse 6. Sie fällt mit der mittigen Symmetrieachse der insbesondere zylinderförmigen Geometrie des SiC-Keimkristalls 2 zusammen. Eine Richtung längs der Kristallmittenlängsachse 6 oder parallel zu derselben wird hier als axial bezeichnet. Eine Richtung senkrecht zu der Kristallmittenlängsachse 6 wird als radial bezeichnet. Tangential ist eine um die Kristallmittenlängsachse 6 umlaufende Umfangsrichtung.

Die Rückseiten-Schichtkomponente 3 hat eine in axialer Richtung gemessene Komponentendicke D, die sich ausgehend von der Kristallmittenlängsachse 6 in radialer Richtung, also hin zum Umfangsrand des SiC-Keimkristalls 2, verändert. Diese Komponentendicke D nimmt in radialer Richtung zu, bei dem in Fig. 1 gezeigten Ausführungsbeispiel mit insgesamt drei diskreten Stufen 7. Die Rückseiten-Schichtkomponente 3 hat eine geometrische Struktur, die sich ausgehend von der Kristallmittenlängsachse 6 in radialer Richtung verändert. Aufgrund dieser radial variierenden Struktur wird während der Züchtung eines SiC-Volumeneinkristalls innerhalb des SiC-Keimkristalls 2 (und insbesondere auch in dem den SiC-Keimkristall 2 umgebenden Bereich sowie in dem aufwachsenden SiC-Volumeneinkristall) ein radialer Temperaturgradient eingestellt, der dazu führt, dass weder im SiC-Keimkristall 2 noch in dem aufwachsenden SiC-Volumeneinkristall innere mechanische Spannungen in nennenswertem Umfang entstehen. Vorzugsweise trägt dieser radiale Temperaturgradient sogar dazu bei, solche inneren Spannungen, wenn sie denn bereits vorhanden sind, abzubauen. Dadurch resultiert letztendlich ein sehr defektfreier SiC-Volumeneinkristall, aus dem auch defektarme SiC-Substrate für die Herstellung von hochqualitativen Bauelementen mit großer Ausbeute gewonnen werden können.

Die variierende Komponentendicke D der Rückseiten-Schichtkomponente 3 nimmt Werte zwischen 1 $\mu$m und 5 $\mu$m an. Insbesondere nimmt die Komponentendicke D ausgehend vom Zentrum bei der Kristallmittenlängsachse 6 hin zum Umfangsrand, also in radialer Richtung, um einen Faktor 5 zu. Am Umfangsrand ist die Komponentendicke D maximal und beträgt dort insbesondere 5 $\mu$m. Die Rückseiten-Schichtkomponente 3 ist bei dem Ausführungsbeispiel gemäß Fig. 1 einlagig ausgebildet. Sie enthält demnach nur eine einzige Einzelschicht. Die Rückseiten-Schichtkomponente besteht aus einem Metallcarbid, beim gezeigten Ausführungsbeispiel gemäß Fig. 1 aus Tantalcarbid (TaC). Bei alternativen, nicht dargestellten Ausführungsbeispielen kann die Rückseiten-Schichtkomponente 3 auch aus einem anderen Schichtmaterial bestehen, beispielsweise aus Graphit oder aus einem anderen Kohlenstoff-Material oder aus einem anderen Carbid, insbesondere aus einem Metallcarbid mit einem hochschmelzenden Metall, wie z. B. Wolfram (W) oder einem anderen Refraktärmetall.

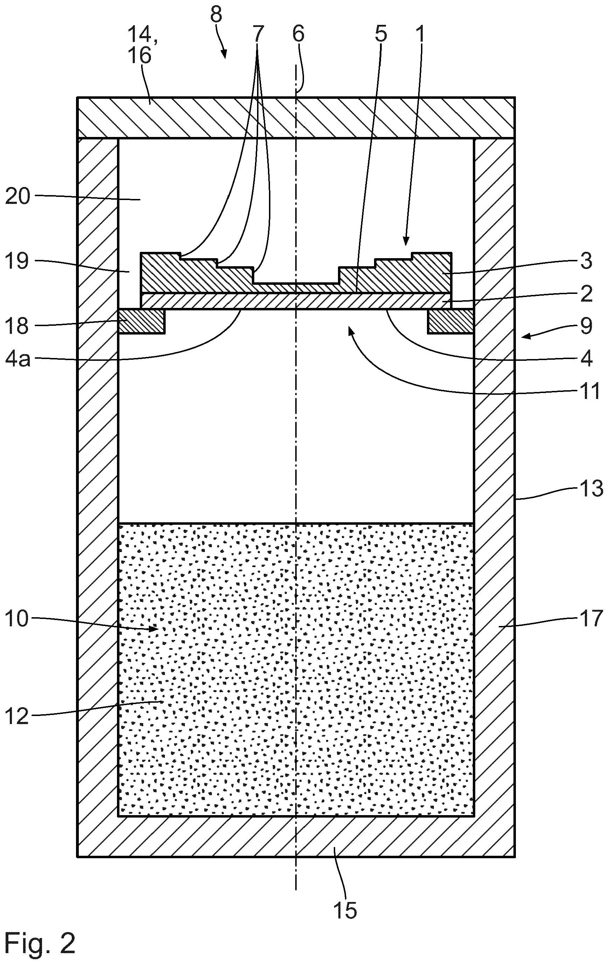

In Fig. 2 ist ein Ausführungsbeispiel einer Züchtungsvorrichtung 8 zur Herstellung eines (wiederum nicht mit dargestellten) SiC-Volumeneinkristalls mittels Sublimationszüchtung dargestellt. Die Züchtungsvorrichtung 8 enthält einen Züchtungstiegel 9, der einen SiC-Vorratsbereich 10 sowie einen Kristallwachstumsbereich 11 umfasst. In dem SiC-Vorratsbereich 10 befindet sich beispielsweise pulverförmiges SiC-Quellmaterial 12.

Der Züchtungstiegel 9 hat ein Tiegelgefäß 13 und einen Tiegeldeckel 14. Der Züchtungstiegel 9 hat eine erste axiale Stirnwand 15, die benachbart zu dem SiC-Vorratsbereich 10 angeordnet ist, und eine dem gegenüberliegende zweite axiale Stirnwand 16, die durch den Tiegeldeckel 14 gebildet ist. Außerdem hat der Züchtungstiegel 9 eine Umfangswand 17, welche wie die erste axiale Stirnwand 15 Bestandteil des Tiegelgefäßes 13 ist. Die Keimeinheit 1 gemäß Fig. 1 ist so im Züchtungstiegel 9 mittels eines Keimhalters 18 positioniert, dass die Scheiben-Vorderseite 4 des SiC-Keimkristalls 2 mit der Wachstumsoberfläche 4a im Kristallwachstumsbereich 11 angeordnet ist. Bei dem gezeigten Ausführungsbeispiel liegt die Scheiben-Vorderseite 4 des SiC-Keimkristalls 2 im Bereich des Umfangsrands lose auf dem ringförmigen Keimhalter 18 auf.

Zwischen der Innenseite der Umfangswand 17 und der Keimeinheit 1 ist ein umlaufender Spalt 19 vorhanden.

Der Züchtungstiegel 9 gemäß Fig. 2 besteht aus einem elektrisch und thermisch leitfähigen Graphit-Tiegelmaterial. Um ihn herum ist eine in Fig. 2 nicht mit dargestellte thermische Isolation angeordnet. Zur Beheizung des Züchtungstiegels 9 ist außerdem eine ebenfalls nicht mit dargestellte, insbesondere induktive Heizeinrichtung, in Form einer Heizspule vorhanden. Der Züchtungstiegel 9 wird mittels dieser Heizeinrichtung auf die für die Züchtung erforderlichen hohen Temperaturen von über 2100° C erhitzt.

Die SiC-Wachstumsgasphase im Kristallwachstumsbereich 11 wird durch das SiC-Quellmaterial 12 gespeist. Die SiC-Wachstumsgasphase enthält zumindest Gasbestandteile in Form von SiC, $Si_2C$ und $SiC_2$ (= SiC-Gasspezies). Der Materialtransport vom SiC-Quellmaterial 12 zu der Wachstumsoberfläche 4a erfolgt längs eines axialen Temperaturgradienten, der mittels der Heizeinrichtung eingestellt wird und parallel zu der Kristallmittenlängsachse 6 verläuft. An der Wachstumsoberfläche 4a herrscht eine relativ hohe Wachstumstemperatur von mindestens 2100° C, insbesondere sogar von mindestens 2200° C oder 2300° C. Dort werden Gasbestandteile der SiC-Wachstumsgasphase abgeschieden, was zum Aufwachsen des SiC-Volumeneinkristalls führt. Die Temperatur nimmt innerhalb des Züchtungstiegels 9 von dem SiC-Quellmaterial 12 in axialer Richtung bis zu dem Tiegeldeckel 14 ab, wodurch der angesprochene axiale Temperaturgradient gebildet wird.

Auf der von dem SiC-Vorratsbereich 10 abgewandten Rückseite der Keimeinheit 1 ist ein Vorrichtungs-Hohlraum 20 angeordnet. Er befindet sich zwischen dem Tiegeldeckel 14 und der Rückseiten-Schichtkomponente 3 der Keimeinheit 1. Dieser Vorrichtungs-Hohlraum 20 trägt zusätzlich zu der radial variierenden Struktur der Rückseiten-Schichtkomponente 3 ebenfalls zur Einstellung des angesprochenen radialen Temperaturgradienten bei. Der Vorrichtungs-Hohlraum 20 ist vorteilhaft, aber dennoch nur optional. Es gibt alternative Ausführungsbeispiele ohne einen solchen Vorrichtungs-Hohlraum 20.

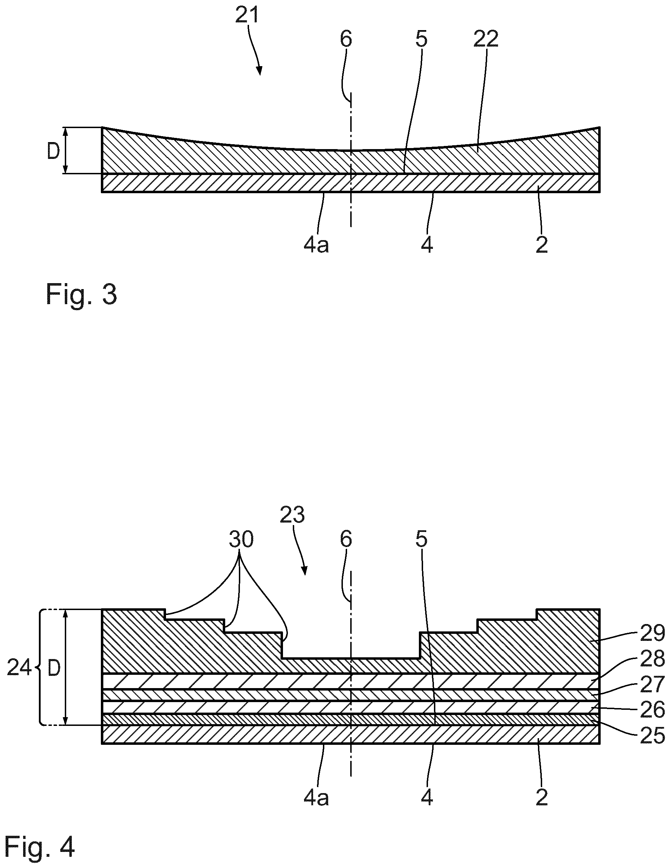

In Fig. 3 ist ein weiteres Ausführungsbeispiel einer Keimeinheit 21 gezeigt. Die Keimeinheit 21 enthält wiederum den SiC-Keimkristall 2 mit Scheiben-Vorderseite 4 und Scheiben-Rückseite 5. Im Unterschied zur Keimeinheit 1 hat die Keimeinheit 21 eine anders ausgestaltete Rückseiten-Schichtkomponente 22. Sie ist wiederum einlagig ausgebildet, bedeckt den SiC-Keimkristall 2 ebenfalls vollständig, und auch ihre Komponentendicke D nimmt ausgehend von der Kristallmittenlängsachse 6 in radialer Richtung bis hin zum Umfangsrand zu, bei dem Ausführungsbeispiel insbesondere um den Faktor 2. Die Zunahme ist in diesem Fall aber nicht gestuft, sondern kontinuierlich. Am Umfangsrand ist die Komponentendicke D maximal und beträgt dort insbesondere 3 μm. Insofern weist auch die Rückseiten-Schichtkomponente 21 eine geometrische Struktur auf, die sich ausgehend von der Kristallmittenlängsachse 6 in radialer Richtung verändert, wodurch während der Züchtung des SiC-Volumeneinkristalls wiederum zumindest innerhalb des SiC-Keimkristalls 2 ein radialer Temperaturgradient eingestellt wird.

In Fig. 4 ist ein weiteres Ausführungsbeispiel einer Keimeinheit 23 gezeigt, die den SiC-Keimkristall 2 und eine bei diesem Ausführungsbeispiel mehrlagig ausgebildete Rückseiten-Schichtkomponente 24 aufweist. Die Rückseiten-Schichtkomponente 24 hat insgesamt fünf Einzelschichten 25, 26, 27, 28 und 29. Die ersten vier direkt auf der Scheiben-Rückseite 5 des SiC-Keimkristalls 2 übereinander aufgebrachten Einzelschichten 25 bis 28 haben jeweils die Form einer ebenen Scheibe und weisen insofern insbesondere an jeder Stelle der betreffenden Einzelschicht 25 bis 28 die gleiche axiale Ausdehnung auf. Bei dem gezeigten Ausführungsbeispiel bestehen diese vier Einzelschichten 25 bis 28 jeweils aus einem thermisch isolierenden Material auf Graphitbasis und bilden ein alternierendes Schichtsystem. Auf diesem Schichtsystem der vier Einzelschichten 25 bis 28 ist auf der vom SiC-Keimkristall 2 abgewandten Seite die äußerste Einzelschicht 29 platziert, welche ähnlich aufgebaut ist, wie die Rückseiten-Schichtkomponente 3 gemäß Fig. 1. Die Einzelschicht 29 hat eine axiale Ausdehnung (= Dicke dieser Einzelschicht), die ausgehend von der Kristallmittenlängsachse 6 in radialer Richtung in drei Stufen 30 zunimmt. Insofern hat die äußerste Einzelschicht 29 und damit die Rückseiten-Schichtkomponente 24 insgesamt wiederum eine geometrische Struktur, die sich in radialer Richtung verändert. Dadurch wird der radiale Temperaturgradient eingestellt. Die äußerste Einzelschicht 29 besteht bei dem Ausführungsbeispiel gemäß Fig. 4 aus einem Metallcarbid, beispielsweise aus Wolframcarbid (WC). Die Rückseiten-Schichtkomponente 24 hat eine axiale Komponentendicke D, die die axiale Ausdehnung aller axial übereinander angeordneten Einzelschichten 25 bis 29 angibt, und die aufgrund der radialen Variation der äußersten Einzelschicht 29 ausgehend von der Kristallmittenlängsachse 6 in radialer Richtung bis hin zum Umfangsrand zunimmt, bei dem Ausführungsbeispiel insbesondere um den Faktor 2. Am Umfangsrand ist die Komponentendicke D maximal und beträgt dort insbesondere 10 $\mu$m.

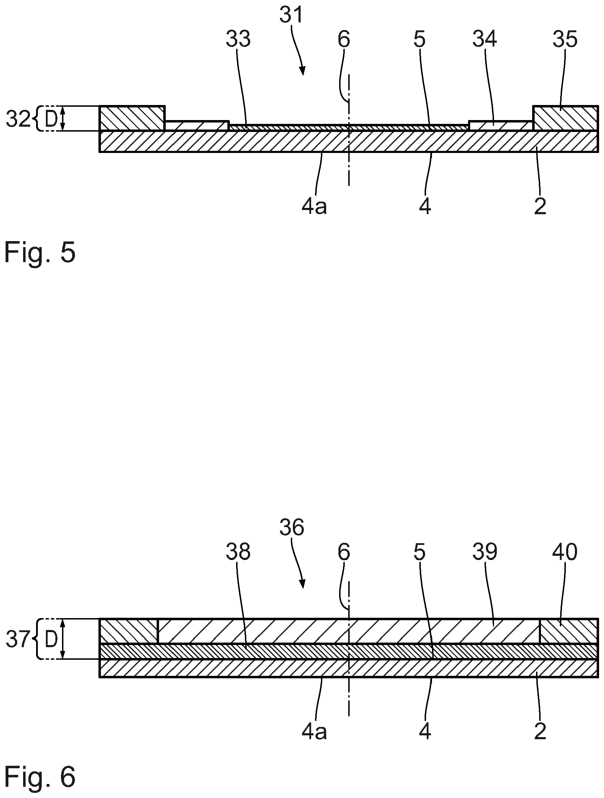

In Fig. 5 ist ein weiteres Ausführungsbeispiel einer Keimeinheit 31 mit dem SiC-Keimkristall 2 und einer weiteren Rückseiten-Schichtkomponente 32 gezeigt. Letztere ist mehrlagig ausgebildet, wobei im Unterschied zu der Rückseiten-Schichtkomponente 24 gemäß Fig. 4 bei dem Ausführungsbeispiel gemäß Fig. 5 die drei Einzelschichten 33, 34 und 35 nicht axial übereinander, sondern radial nebeneinander und konzentrisch zur Kristallmittenlängsachse 6 angeordnet sind. Die zentrale Einzelschicht 33 ist als zylindrische Vollscheibe ausgebildet und hat die geringste (einheitliche) Einzelschichtdicke in axialer Richtung, bei dem Ausführungsbeispiel insbesondere 1 $\mu$m. Die radial an die zentrale Einzelschicht 33 unmittelbar angrenzende mittlere Einzelschicht 34 ist als ringförmiger Körper ausgebildet und hat eine (einheitliche) Einzelschichtdicke, die größer als die der inneren Einzelschicht 33 ist, bei dem Ausführungsbeispiel insbesondere 2 $\mu$m. Die äußere Einzelschicht 35 grenzt unmittelbar an die mittlere Einzelschicht 34 an und hat ihr gegenüber eine noch größere (einheitliche) Einzelschichtdicke, bei dem Ausführungsbeispiel insbesondere 5 $\mu$m. Auch die Komponentendicke D der Rückseiten-Schichtkomponente 32 nimmt somit ausgehend von der Kristallmittenlängsachse 6 in radialer Richtung bis hin zum Umfangsrand zu, bei dem Ausführungsbeispiel insbesondere um den Faktor 5. Für die Rückseiten-Schichtkomponente 32 resultiert insgesamt wiederum eine Struktur, deren Geometrie sich ausgehend von der Kristallmittenlängsachse 6 in radialer Richtung verändert. Die Einzelschichten 33, 34 und 35 bestehen bei dem Ausführungsbeispiel gemäß Fig. 5 jeweils aus einem unterschiedlichen thermisch isolierenden Schichtmaterial auf Graphitbasis.

In Fig. 6 ist ein weiteres Ausführungsbeispiel einer Keimeinheit 36 mit dem SiC-Keimkristall 2 und einer weiteren Rückseiten-Schichtkomponente 37 gezeigt. Auch die Rückseiten-Schichtkomponente 37 ist mehrlagig ausgeführt und setzt sich zusammen aus einer unteren Einzelschicht 38, die dem SiC-Keimkristall 2 an dessen Scheiben-Rückseite 5 vollflächig kontaktiert und bedeckt, sowie einer zweiteiligen oberen Lage mit einer scheibenförmigen, mittigen Einzelschicht 39 und einer diese konzentrisch umgebenden randseitigen Einzelschicht 40 in ringförmiger Gestalt. Die Rückseiten-Schichtkomponente 37 hat an jeder Stelle die gleiche axiale Ausdehnung. Die Komponentendicke D ist bei diesem Ausführungsbeispiel überall gleich. Sie beträgt beispielsweise 4 $\mu$m. Allerdings bestehen insbesondere zumindest die beiden Einzelschichten 39 und 40 der oberen bzw. äußeren Lage jeweils aus einem anderen Schichtmaterial, so dass sich bei diesem Ausführungsbeispiel die Struktur der Rückseiten-Schichtkomponente 37 unter dem Gesichtspunkt der Materialzusammensetzung ausgehend von der Kristallmittenlängsachse in radialer Richtung verändert und aufgrund dessen auch bei diesem Ausführungsbeispiel die erwünschte Einstellung eines radialen Temperaturgradienten während der Züchtung des SiC-Volumeneinkristalls resultiert.

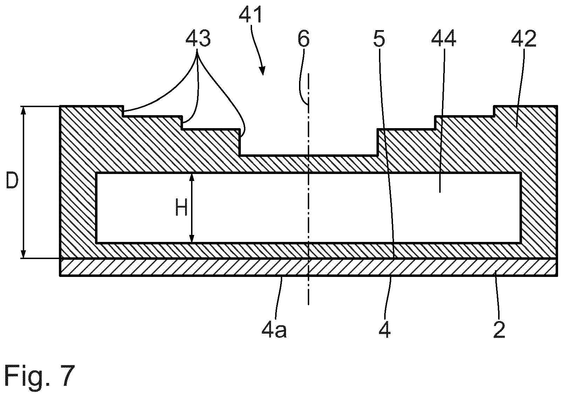

In Fig. 7 ist ein weiteres Ausführungsbeispiel einer Keimeinheit 41 mit dem SiC-Keimkristall 2 und einer weiteren einlagigen Rückseiten-Schichtkomponente 42 dargestellt. Die von der Scheiben-Rückseite 5 des SiC-Keimkristalls 2 abgewandte Seite der Rückseiten-Schichtkomponente 42 hat eine unebene Kontur mit drei konzentrischen Stufen 43 vergleichbar zu den Rückseiten-Schichtkomponenten 3 und 24. Deshalb nimmt auch die Komponentendicke D der Rückseiten-Schichtkomponente 42 ausgehend von der Kristallmittenlängsachse 6 in radialer Richtung bis hin zum Umfangsrand zu, bei dem Ausführungsbeispiel insbesondere um den Faktor 1,5. Im Zentrum beträgt die Komponentendicke D beispielsweise 4 mm, am Umfangsrand, wo sie ihre maximale axiale Ausdehnung hat, beispielsweise 6 mm. Zusätzlich ist im Inneren der Rückseiten-Schichtkomponente 42 ein Schicht-Hohlraum 44 vorhanden, welcher eine axiale Hohlraumhöhe H von etwa 3 mm hat. Die Rückseiten-Schichtkomponente 42 hat aufgrund ihrer rückseitigen Oberflächenkontur eine sich in radialer Richtung verändernde Struktur. Deshalb und auch aufgrund des Schicht-Hohlraums 44 wird die Einstellung eines radialen Temperaturgradienten während der Züchtung des SiC-Volumeneinkristalls bewirkt.

Die Keimeinheiten 21, 23, 31, 36 und 41 können bei der Vorrichtung 8 gemäß Fig. 2 anstelle der dort eingesetzten Keimeinheit 1 zur Züchtung eines SiC-Volumeneinkristalls verwendet werden. Alle Keimeinheiten 1, 21, 23, 31, 36 und 41 zeichnen sich dadurch aus, dass sie eine insbesondere getrennte Einstellung des radialen Temperaturgradienten und des axialen Temperaturgradienten innerhalb der Züchtungsvorrichtung 8 ermöglichen und somit zu einem besonders defektarmen Aufwachsen des SiC-Volumeneinkristalls beitragen.

**Patentansprüche**

1. Keimeinheit für die Züchtung eines SiC-Volumeneinkristalls aufweisend

    a) einen scheibenförmigen einkristallinen SiC-Keimkristall (2) mit einer an einer Scheiben-Vorderseite (4) angeordneten Wachstumsoberfläche (4a) zum Aufwachsen des zu züchtenden SiC-Volumeneinkristalls,
    a1) wobei der SiC-Keimkristall (2) eine in einer axialen Richtung verlaufende Kristallmittenlängsachse (6) hat, und eine radiale Richtung senkrecht zur axialen Richtung orientiert ist,
    und
    b) eine an einer Scheiben-Rückseite (5) des SiC-Keimkristalls (2) angeordnete Rückseiten-Schichtkomponente (3; 22; 24; 32; 37; 42),

b1) deren Struktur sich ausgehend von der Kristallmittenlängsachse (6) in radialer Richtung verändert, so dass sich während der Züchtung des SiC-Volumeneinkristalls innerhalb des SiC-Keimkristalls (2) ein radialer Temperaturgradient einstellt.

2. Keimeinheit nach Anspruch 1, **dadurch gekennzeichnet, dass** die Rückseiten-Schichtkomponente (3; 22; 42) aus einer Einzelschicht besteht.

3. Keimeinheit nach Anspruch 2, **dadurch gekennzeichnet, dass** die Einzelschicht eine axiale Schichtdicke zwischen 0,5 $\mu$m und 10 $\mu$m, insbesondere zwischen 1 $\mu$m und 5 $\mu$m, hat.

4. Keimeinheit nach Anspruch 1, **dadurch gekennzeichnet, dass** die Rückseiten-Schichtkomponente (24; 32; 37) aus mehreren Einzelschichten (25, 26, 27, 28, 29; 33, 34, 35; 38, 39;40) besteht.

5. Keimeinheit nach Anspruch 4, **dadurch gekennzeichnet, dass** zumindest ein Teil der mehreren Einzelschichten (25, 26, 27, 28, 29; 33, 34, 35; 38, 39;40) axial übereinander und/oder radial nebeneinander angeordnet ist.

6. Keimeinheit nach Anspruch 4 oder 5, **dadurch gekennzeichnet, dass** eine axiale Gesamtschichtdicke aller Einzelschichten (25, 26, 27, 28, 29; 33, 34, 35; 38, 39;40) zwischen 0,5 $\mu$m und 20 $\mu$m, insbesondere zwischen 1 $\mu$m und 10 $\mu$m, liegt.

7. Keimeinheit nach einem der Ansprüche 4 bis 6, **dadurch gekennzeichnet, dass** die Einzelschichten (25, 26, 27, 28, 29; 33, 34, 35; 38, 39;40) zumindest zum Teil ein voneinander verschiedenes Schichtmaterial haben.

8. Keimeinheit nach einem der Ansprüche 2 bis 7, **dadurch gekennzeichnet, dass** jede Einzelschicht (25, 26, 27, 28, 29; 33, 34, 35; 38, 39;40) der Rückseiten-Schichtkomponente (3; 22; 24; 32; 37; 42) aus einem Schichtmaterial besteht, welches ein Material aus der Gruppe von Kohlenstoff und einem Carbid ist oder zumindest ein Material dieser Gruppe aufweist.

9. Keimeinheit nach einem der vorhergehenden Ansprüche, **dadurch gekennzeichnet, dass** die Rückseiten-Schichtkomponente (3; 22; 24; 32; 42) eine axiale Komponentendicke hat, die ausgehend von der Kristallmittenlängsachse (6) in radialer Richtung zunimmt.

10. Keimeinheit nach Anspruch 9, **dadurch gekennzeichnet, dass** die axiale Komponentendicke kontinuierlich oder mit diskreten Stufen zunimmt.

11. Keimeinheit nach einem der vorhergehenden Ansprüche, **dadurch gekennzeichnet, dass** die Rückseiten-Schichtkomponente (3; 22; 24; 32; 37; 42) direkt an der Scheiben-Rückseite (5) des SiC-Keimkristalls (2) anliegt.

12. Keimeinheit nach einem der vorhergehenden Ansprüche, **dadurch gekennzeichnet, dass** die Rückseiten-Schichtkomponente (42) einen Schicht-Hohlraum (44) aufweist.

13. Keimeinheit nach Anspruch 12, **dadurch gekennzeichnet, dass** der Schicht-Hohlraum (44) eine axiale Ausdehnung von bis zu 5 mm hat.

14. Vorrichtung zur Züchtung eines SiC-Volumeneinkristalls aufweisend

a) einen beheizbaren Züchtungstiegel (9) mit einem in einem ersten Abschnitt angeordneten SiC-Vorratsbereich (10) zur Aufnahme von SiC-Quellmaterial (12), und mit einem in einem zweiten Abschnitt angeordneten Kristallwachstumsbereich (11),
b) eine Keimeinheit (1; 21; 23; 31; 36; 41) nach einem der vorhergehenden Ansprüche, und
c) einen Keimhalter (18) zur Halterung der Keimeinheit (1; 21; 23; 31; 36; 41) im Inneren des Züchtungstiegels (9), so dass zumindest die Wachstumsoberfläche (4a) des SiC-Keimkristalls (2) der Keimeinheit (1; 21; 23; 31; 36; 41) in dem Kristallwachstumsbereich (11) angeordnet ist.

15. Vorrichtung nach Anspruch 14, **dadurch gekennzeichnet, dass** auf einer von dem SiC-Vorratsbereich (10) abgewandten Rückseite der Keimeinheit (1; 21; 23; 31; 36; 41) ein Vorrichtungs-Hohlraum (20) angeordnet ist, der insbesondere eine axiale Ausdehnung von bis zu 5 mm hat.

Fig. 1

Fig. 2

Fig. 3

Fig. 4

Fig. 5

Fig. 6

Fig. 7

Europäisches
Patentamt

European
Patent Office

Office européen
des brevets

# EUROPÄISCHER RECHERCHENBERICHT

Nummer der Anmeldung

EP 24 16 2679

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2011/300323 A1 (STRAUBINGER THOMAS [DE] ET AL) 8. Dezember 2011 (2011-12-08) | 1,2,4,5, 7,8, 11-15 | INV. C30B23/06 C30B29/36 |
| A | * Abbildungen 1, 4 * <br> * Absätze [0044], [0054] - [0056], [0058], [0059] * <br> - - - - - | 3,6 | C30B23/02 |
| X | US 2023/243064 A1 (WELLMANN PETER [DE]) 3. August 2023 (2023-08-03) | 1,2,4,5, 8-15 | |
| A | * Abbildung 5b * <br> * Absätze [0027], [0160], [0161] * <br> - - - - - | 3,6 | |
| A | PONS M ET AL: "State of the art in the modelling of SiC sublimation growth", MATERIALS SCIENCE AND ENGINEERING: B, ELSEVIER, AMSTERDAM, NL, Bd. 61-62, 30. Juli 1999 (1999-07-30), Seiten 18-28, XP027362538, ISSN: 0921-5107 [gefunden am 1999-07-30] | 1-15 | |
| | * Abbildungen 1-5 * <br> - - - - - | | RECHERCHIERTE SACHGEBIETE (IPC) |
| A | US 2019/211472 A1 (HOSHINO MASAHIRO [JP] ET AL) 11. Juli 2019 (2019-07-11) * Abbildung 8 * <br> - - - - - | 1-15 | C30B |

Der vorliegende Recherchenbericht wurde für alle Patentansprüche erstellt

| Recherchenort | Abschlußdatum der Recherche | Prüfer |
|---|---|---|
| Den Haag | 30. Juli 2024 | Schmitt, Christian |

**ANHANG ZUM EUROPÄISCHEN RECHERCHENBERICHT
ÜBER DIE EUROPÄISCHE PATENTANMELDUNG NR.**
EP 24 16 2679

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

30-07-2024

| Im Recherchenbericht angeführtes Patentdokument | Datum der Veröffentlichung | Mitglied(er) der Patentfamilie | Datum der Veröffentlichung |
|---|---|---|---|
| US 2011300323 A1 | 08-12-2011 | DE 102010029756 A1 | 08-12-2011 |
| | | US 2011300323 A1 | 08-12-2011 |
| US 2023243064 A1 | 03-08-2023 | CN 115768929 A | 07-03-2023 |
| | | DE 102020117661 A1 | 20-01-2022 |
| | | DE 202021102935 U1 | 24-06-2021 |
| | | EP 4176107 A1 | 10-05-2023 |
| | | JP 2023543105 A | 13-10-2023 |
| | | KR 20230030659 A | 06-03-2023 |
| | | TW 202202677 A | 16-01-2022 |
| | | US 2023243064 A1 | 03-08-2023 |
| | | WO 2022002745 A1 | 06-01-2022 |
| US 2019211472 A1 | 11-07-2019 | CN 106119954 A | 16-11-2016 |
| | | JP 2019528233 A | 10-10-2019 |
| | | US 2019211472 A1 | 11-07-2019 |
| | | WO 2018040897 A1 | 08-03-2018 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 8865324 B2
- CN 116121855 A
- US 20110229719 A1
- CN 218860954 U
- CN 218175203 U